# EUROPEAN PATENT SPECIFICATION

(11) **EP 3 798 790 B1**
(45) Date of publication and mention of the grant of the patent: **15.01.2025**
(21) Application number: 20181124.7
(22) Date of filing: 19.06.2020
(51) Int. Cl.: G06F 1/16, G09F 9/30, H10K 59/80

(54) **FLEXIBLE CHASSIS FOR A FLEXIBLE DISPLAY**
FLEXIBLES CHASSIS FÜR EINE FLEXIBLE ANZEIGE
CHÂSSIS SOUPLE POUR AFFICHAGE SOUPLE

(30) Priority: 27.09.2019 US 201916585907
(43) Date of publication of application: 31.03.2021
(73) Proprietor: Intel Corporation, Santa Clara, CA 95054 (US)
(72) Inventor: Moore, Christopher, Santa Clara, CA 95054 (US); Fricke, Gustavo, Santa Clara, CA 95054 (US); Paavola, Juha, Santa Clara, CA 95054 (US); Makinen, Mikko, Santa Clara, CA 95054 (US)
(74) Representative: Rummler, Felix

(56) References cited:
- US-A1- 2014 111 954
- US-A1- 2014 226 275
- US-A1- 2017 227 994
- US-A1- 2019 179 373

## Description

### TECHNICAL FIELD

This disclosure relates in general to the field of computing, and more particularly, to a flexible chassis for a flexible display.

### BACKGROUND

End users have more electronic device choices than ever before. A number of prominent technological trends are currently afoot (e.g., more computing devices, more devices that can change into different configurations, etc.), and these trends are changing the electronic device landscape. One of the technological trends is a flexible display. A flexible display is an electronic visual display that can bend or flex.

US 2017/227994 A1 relates to a coupling device assembled on an electronic apparatus with a flexible unfoldable/foldable display screen. US 2014/226275 A1 relates to a flexible portable terminal capable of bending or folding in a direction to a front surface or a rear surface thereof without a flexible display unit being separated from the flexible portable terminal or being damaged. US 2014/111954 A1 relates to a foldable display device including a case which can stably support a flexible display panel. US 2019/179373 A1 relates to a hinge of a mobile terminal with a flexible screen.

### BRIEF DESCRIPTION OF THE DRAWINGS

To provide a more complete understanding of the present invention and features and advantages thereof, reference is made to the following description, taken in conjunction with the accompanying figures, wherein like reference numerals represent like parts, in which:
FIGURE 1A is a simplified block diagram of an electronic device to enable a flexible chassis for a flexible display, in accordance with an embodiment of the present disclosure;
FIGURE 1B is a simplified block diagram of an electronic device to enable a flexible chassis for a flexible display, in accordance with an embodiment of the present disclosure;
FIGURE 1C is a simplified block diagram of an electronic device to enable a flexible chassis for a flexible display, in accordance with an embodiment of the present disclosure;
FIGURE 1D is a simplified block diagram of an electronic device to enable a flexible chassis for a flexible display, in accordance with an embodiment of the present disclosure;
FIGURE 1E is a simplified block diagram of an electronic device to enable a flexible chassis for a flexible display, in accordance with an embodiment of the present disclosure;
FIGURE 1F is a simplified block diagram of an electronic device to enable a flexible chassis for a flexible display, in accordance with an embodiment of the present disclosure;
FIGURE 2 is a simplified block diagram exploded view of an electronic device to enable a flexible chassis for a flexible display, in accordance with an embodiment of the present disclosure;
FIGURE 3 is a simplified block diagram exploded view of an electronic device to enable a flexible chassis for a flexible display, in accordance with an embodiment of the present disclosure;
FIGURE 4 is a simplified block diagram of a portion of an electronic device to enable a flexible chassis for a flexible display, in accordance with an embodiment of the present disclosure;
FIGURE 5 is a simplified block diagram of a portion of an electronic device to enable a flexible chassis for a flexible display, in accordance with an embodiment of the present disclosure;
FIGURE 6 is a simplified block diagram exploded view of an electronic device to enable a flexible chassis for a flexible display, in accordance with an embodiment of the present disclosure;
FIGURE 7 is a simplified block diagram of a portion of an electronic device to enable a flexible chassis for a flexible display, in accordance with an embodiment of the present disclosure;
FIGURE 8 is a simplified block diagram of a portion of an electronic device to enable a flexible chassis for a flexible display, in accordance with an embodiment of the present disclosure;
FIGURE 9 is a simplified block diagram of a portion of an electronic device to enable a flexible chassis for a flexible display, in accordance with an embodiment of the present disclosure;
FIGURE 10 is a simplified block diagram of a portion of an electronic device to enable a flexible chassis for a flexible display, in accordance with an embodiment of the present disclosure;
FIGURE 11A is a simplified block diagram of a portion of an electronic device to enable a flexible chassis for a flexible display, in accordance with an embodiment of the present disclosure;
FIGURE 11B is a simplified block diagram of a portion of an electronic device to enable a flexible chassis for a flexible display, in accordance with an embodiment of the present disclosure;
FIGURE 11C is a simplified block diagram of a portion of an electronic device to enable a flexible chassis for a flexible display, in accordance with an embodiment of the present disclosure;
FIGURE 11D is a simplified block diagram of a portion of an electronic device to enable a flexible chassis for a flexible display, in accordance with an embodiment of the present disclosure;
FIGURE 12 is a simplified block diagram of a portion of an electronic device to enable a flexible chassis for a flexible display, in accordance with an embodiment of the present disclosure;
FIGURE 13 is a simplified block diagram of a portion of an electronic device to enable a flexible chassis for a flexible display, in accordance with an embodiment of the present disclosure;
FIGURE 14 is a simplified block diagram of a portion of an electronic device to enable a flexible chassis for a flexible display, in accordance with an embodiment of the present disclosure;
FIGURE 15 is a simplified block diagram of a portion of an electronic device to enable a flexible chassis for a flexible display, in accordance with an embodiment of the present disclosure; and
FIGURE 16 is a simplified block diagram of an electronic device to enable a flexible chassis for a flexible display, in accordance with an embodiment of the present disclosure.
The FIGURES of the drawings are not necessarily drawn to scale, as their dimensions can be varied considerably without departing from the scope of the present disclosure.

### DETAILED DESCRIPTION

### EXAMPLE EMBODIMENTS

The following detailed description sets forth examples of apparatuses, methods, and systems relating to a system for enabling a flexible chassis for a flexible display. Features such as structure(s), function(s), and/or characteristic(s), for example, are described with reference to one embodiment as a matter of convenience; various embodiments may be implemented with any suitable one or more of the described features.

In the following description, various aspects of the illustrative implementations will be described using terms commonly employed by those skilled in the art to convey the substance of their work to others skilled in the art. However, it will be apparent to those skilled in the art that the embodiments disclosed herein may be practiced with only some of the described aspects. For purposes of explanation, specific numbers, materials, and configurations are set forth in order to provide a thorough understanding of the illustrative implementations. However, it will be apparent to one skilled in the art that the embodiments disclosed herein may be practiced without the specific details. In other instances, well-known features are omitted or simplified in order not to obscure the illustrative implementations.

The terms "over," "under," "below," "between," and "on" as used herein refer to a relative position of one layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "directly on" a second layer is in direct contact with that second layer. Similarly, unless explicitly stated otherwise, one feature disposed between two features may be in direct contact with the adjacent features or may have one or more intervening layers.

In the following detailed description, reference is made to the accompanying drawings that form a part hereof wherein like numerals designate like parts throughout, and in which is shown, by way of illustration, embodiments that may be practiced. It is to be understood that other embodiments may be utilized and structural or logical changes may be made without departing from the scope of the present disclosure. Therefore, the following detailed description is not to be taken in a limiting sense. For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). Reference to "one embodiment" or "an embodiment" in the present disclosure means that a particular feature, structure, or characteristic described in connection with the embodiment is included in at least one embodiment. The appearances of the phrase "in one embodiment" or "in an embodiment" are not necessarily all referring to the same embodiment. The appearances of the phrase "for example," "in an example," or "in some examples" are not necessarily all referring to the same example.

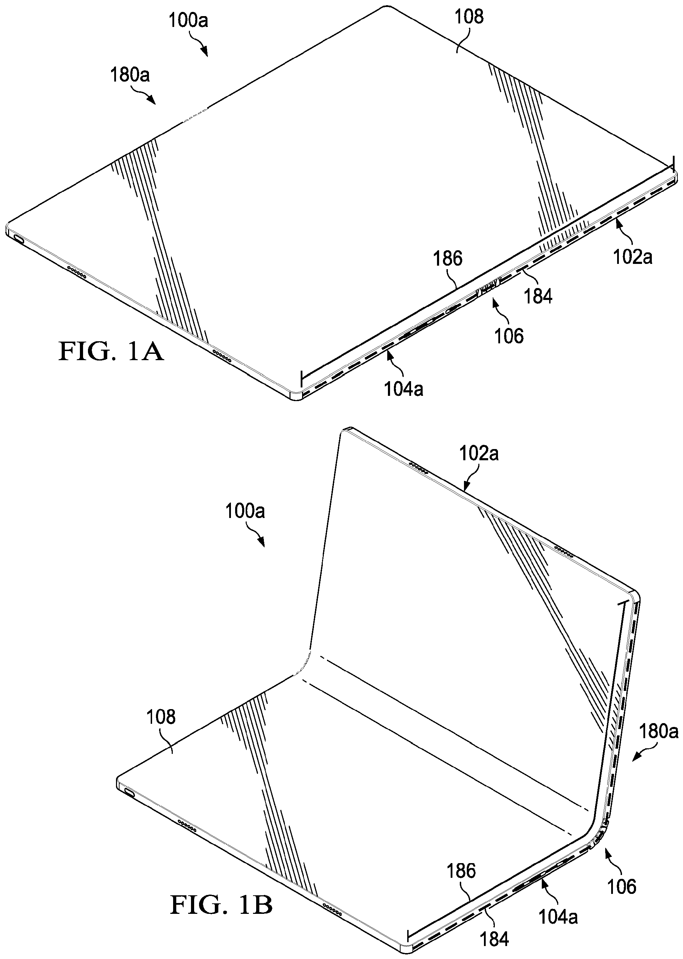

FIGURE 1A is a simplified block diagram of an electronic device 100a configured with a flexible chassis for a flexible display, in accordance with an embodiment of the present disclosure. In an example, electronic device 100a can include a flexible display 108 and a chassis 180a. Chassis 180a can include a first portion chassis 102a, a second portion chassis 104a, and a hinge 106. Flexible display 108 may be a foldable organic light emitting diode (FOLED) display or some other flexible display. As electronic device 100a is bent, chassis 180a can flex to accommodate a change in position of chassis 180a relative to flexible display 108. This allows chassis 180a to provide the support for flexible display 108 while accommodating a change in position of chassis 180a relative to flexible display 108 as electronic device 100a is bent.

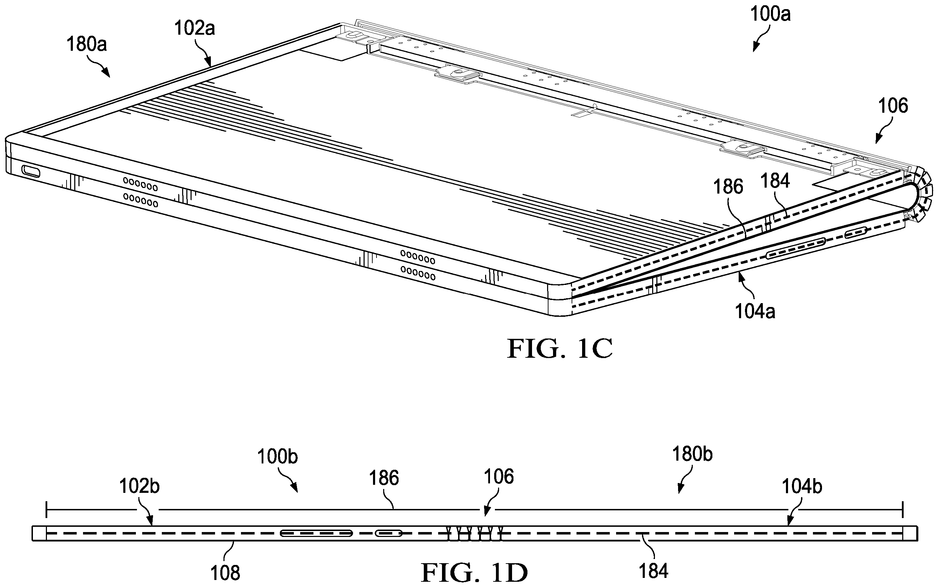

As illustrated in FIGURE 1A, electronic device 100a is in a flat configuration with flexible display 108 on a first side of electronic device 100a. First portion chassis 102a and second portion chassis 104a provide a relatively flat and uniform surface for flexible display 108. As illustrated in FIGURE 1B, first portion chassis 102a can be rotated about hinge 106 towards second portion chassis 104a such that flexible display 108 is bent and electronic device 100a is in an open configuration. As illustrated in FIGURE 1C, first portion chassis 102a can be rotated about hinge 106 towards second portion chassis 104a such that flexible display 108 is bent and electronic device 110a is in a closed configuration with flexible display 108 facing inward. As used herein, the term "bend," (and its derivatives) includes "curve," "fold," and other similar terms that connote moving one end of an object towards an opposite end of the object (e.g., moving first portion chassis 102a towards second portion chassis 104a).

As electronic device 100a is bent, it experiences a distortion such that material nearer the outside convex surface of the bend is forced to stretch and comes into tension, while material nearer the inside concave surface of the bend comes into compression. In the cross section of electronic device 100a, there is a plane called a neutral axis 184 that separates the tension and compression zones. Neutral axis 184 is an area within the bend where the material goes through no physical change during forming of the bend. On the outside of neutral axis 184, the material of electronic device 100a is expanding while on the inside of neutral axis 184 the material of electronic device 100a is compressing. This causes the inside surface, which includes flexible display 108, to extend outside or past the outside surface, which includes chassis 180a. More specifically, flexible display 108, being inside of the bent neutral axis, needs to bend to a smaller radius due to the bending arc length of flexible display 108 being smaller than the bending arc length of chassis 180a and therefore, the ends of flexible display 108 will move further and are longer than the ends of chassis 180a. Electronic device 100a can be configured to allow flexible display 108 and chassis 180a to move relative to each other to accommodate the change in position of chassis 180a relatively to flexible display 108 such that the ends of flexible display 108 and chassis 180a are in the same plane when electronic device 100a is in a flat configuration as well as when electronic device 100a is bent and/or transitioning or has transitioned to a closed configuration.

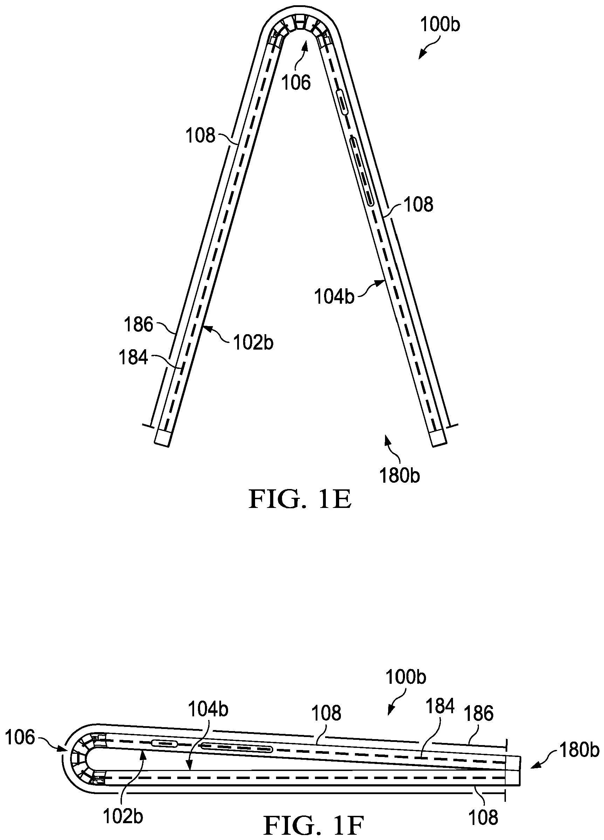

Turning to FIGURE 1D, FIGURE 1D is a simplified block diagram of an electronic device 100b configured with a flexible chassis for a flexible display, in accordance with an embodiment of the present disclosure. In an example, electronic device 100b can include flexible display 108 and a chassis 180b. Chassis 180b can include a first portion chassis 102b, a second portion chassis 104b, and hinge 106. As illustrated in FIGURE 1D, electronic device 100b is in a flat configuration with flexible display 108 on a second side of electronic device 100b. As illustrated in FIGURE 1E, first portion chassis 102b can be rotated on hinge 106 away from second portion chassis 104b such that flexible display 108 is bent and electronic device 100b is in a tent configuration. As illustrated in FIGURE 1F, first portion chassis 102b can be rotated on hinge 106 away from second portion chassis 104b such that flexible display 108 is bent and electronic device is in a tablet configuration with flexible display 108 facing outward from electronic device 100b.

As electronic device 100b is bent, it experiences a distortion such that material nearer the outside convex surface of the bend is forced to stretch and comes into tension, while material nearer the inside concave surface of the bend comes into compression. The cross section of electronic device 100b includes neutral axis 184 that separates the tension and compression zones. On the outside of neutral axis 184, the material of electronic device 100b is expanding while on the inside of neutral axis 184 the material of electronic device 100b is compressing. This causes the inside surface, which includes chassis 180b, to extend outside or past the outside surface, which includes flexible display 108. More specifically, chassis 180b, being inside of the bent neutral axis 184, needs to bend to a smaller radius due to the bending arc length of chassis 180b being smaller than the bending arc length of flexible display 108 and therefore, the ends of chassis 180b will move further and are longer than the ends of flexible display 108.

Electronic device 100b can be configured to allow flexible display 108 and chassis 180b to move relative to each other to accommodate the change in position of chassis 180b relatively to flexible display 108 such that the ends of flexible display 108 and chassis 180b are in the same plane when electronic device 100b is in a flat configuration and is bent and/or transitioning or has transitioned to a tablet configuration. In an example, each of chassis 180a and 180b are designed to support flexible display 108 in a lay-flat configuration as well as bend with flexible display 108 from about zero degrees (0°) to about one-hundred and eighty degrees (180°) without damaging flexible display 108. In another example, hinge 106 can allow for about three-hundred and sixty degrees (360°) of rotation and chassis 180a and 180b can be designed to support flexible display 108 from about zero degrees (0°) to about three-hundred and sixty degrees (360°) of rotation without damaging flexible display 108.

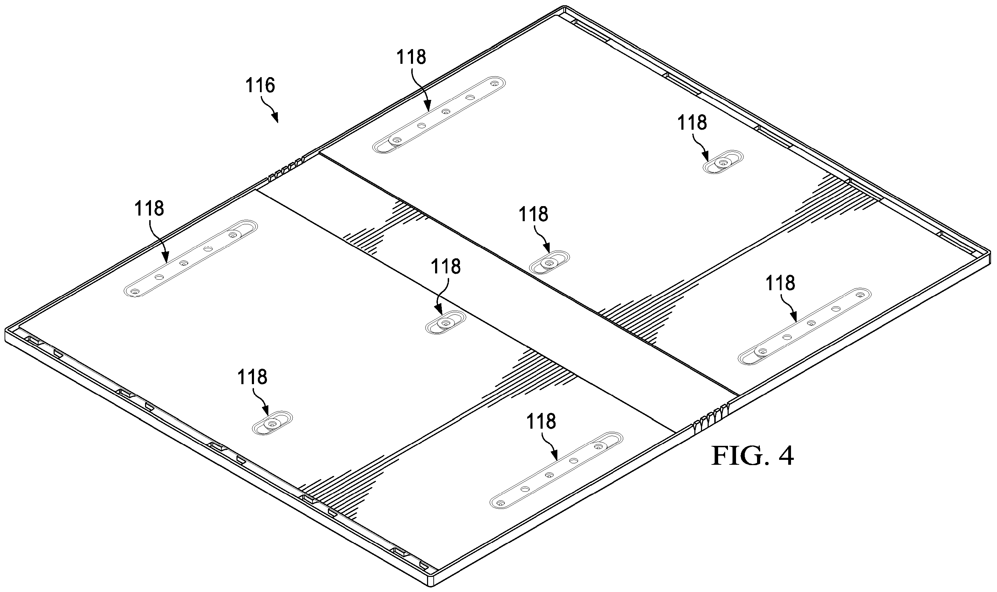

Chassis 180a is configured to provide support for flexible display 108 while accommodating the change in position of chassis 180a relatively to flexible display 108 as flexible display 108 is bent. In addition, chassis 180b is configured to provide support for flexible display 108 while accommodating the change in position of chassis 180b relatively to flexible display 108 as flexible display 108 is bent. If chassis 180a or 180b are not configured to accommodate the change in position of chassis 180a or 180b relative to flexible display 108 as flexible display 108 is bent, flexible display 108 could become damaged due to the stresses generated from the bend. In a specific example, to accommodate the change in position of chassis 180a relatively to flexible display 108, chassis 180a is configured to provide support for flexible display 108 by means of elongating the coupling or connection of hinge 106 to first portion chassis 102a or second portion chassis 104a. Similarly, to accommodate the change in position of chassis 180b relatively to flexible display 108, chassis 180b is configured to provide support for flexible display 108 by means of elongating the coupling or connection of hinge 106 to first portion chassis 102b or second portion chassis 104b. In another specific example, to accommodate the change in position of chassis 180a or 108b relatively to flexible display 108, each of chassis 180a and 180b are configured to provide support for flexible display 108 by allowing the flexible display to slide along a sub-frame (e.g., sliding display frame 116 illustrated in FIGURE 4) as chassis 180a and 180 change position relative to flexible display 108 when flexible display 108 is bent.

It is to be understood that other embodiments may be utilized and structural changes may be made. Substantial flexibility is provided by electronic devices 100a and 100b. The scope of the present invention is defined in the appended claims.

For purposes of illustrating certain example techniques of electronic devices 100a and 100b, the following foundational information may be viewed as a basis from which the present invention may be properly explained. End users have more media and communications choices than ever before. A number of prominent technological trends are currently afoot (e.g., more computing devices, more online video services, etc.), and these trends are changing the media delivery landscape. One of the technological trends is a flexible display. A flexible display is an electronic visual display that can bend. One issue with flexible displays is the support or chassis for the flexible display as the support or chassis can often limit the form-factor of the device.

For example, flexible displays might not have a cover layer made of glass and materials that are used for the support (e.g., chassis) of the flexible display can be prone to permanent deformation that will be detrimental to the device aesthetics and can also reduce the user experience due to a distorted image. More specifically, when the flexible display and support are in a flat configuration, the ends of the flexible display and the support are the same. However, when the flexible display and support bend, the length of the flexible display and the ends of the support become different. This is because as material is bent, the inside portion undergoes compression due to the smaller radius in the bending arc length and the outside portion undergoes expansion or is stretched due to the larger radius in the bending arch length. This causes the ends of the inside surface to extend past the ends of the outside surface. Some current devices that include a flexible display do not provide the necessary support for the flexible display while accommodating the required change in position of the support relative to the flexible display as the flexible display is bent. Currently, there are no available mechanisms for flexible display devices that allow the flexible display to be relatively flat and can accommodate the change in position of the support of the flexible display relatively to the flexible display as the flexible display is bent.

A chassis to help mitigate the challenges of supporting a flexible display, as outlined in FIGURES 1A-1F, can resolve these issues (and others). For example, an electronic device (e.g., electronic device 100a or electronic device 100b) can be configured to allow for a flexible chassis for a flexible display. More specifically, the electronic device can be configured to include a flexible chassis (e.g., chassis 180a or 180b) that provides a relatively flat and uniform surface for the flexible display. The flexible chassis can be designed to support the flexible display in a lay-flat mode and have an even bend with the flexible display from about zero degrees (0°) to about one hundred and eighty degrees (180°) of rotation or from about zero degrees (0°) to about three-hundred and sixty degrees (360°) of rotation without damaging the flexible display itself.

The flexible chassis is designed to be either rigid or flexible, depending on whether the flexible chassis is flattened out in a flat configuration or bent in an open configuration, closed configuration, tent configuration, tablet configuration, or some other configuration where the flexible display is bent In an example, the flexible display support is designed to support and protect the flexible display and the shape of the flexible display support can be configured to produce a self-straightening action in a flat configuration.

In some examples, the flexible display support can slide inside the flexible chassis from one end or both ends. In an example, one or more slide mechanisms can guide the sliding movement of the flexible display support. The one or more slide mechanisms can create a force that keeps a first portion of the flexible chassis, a second portion of the flexible chassis, and the flexible display support against the hinge to help prevent the flexible display from flattening in the bend area.

In some examples which are not encompassed by the wording of the claims but are considered as useful for understanding the invention, alternative to the slide mechanisms within the flexible chassis, a hinge can provide the necessary movement to allow for the electronic device to accommodate the difference in position of the flexible chassis relative to the flexible display. More specifically, a telescoping motion or growth of the hinge is necessary due to the additional arc length of the flexible chassis relative to the flexible display as the electronic device approaches a closed configuration (e.g., the flexible display, being inside of the bent neutral axis needs to bend to a smaller radius due to the bending arc length of the flexible display being smaller than the bending arc length of the flexible chassis) or the reduced arc length of the flexible chassis relative to the flexible display as the electronic device approaches a tablet configuration (e.g., the flexible display, being outside of the bent neutral axis, needs to bend to a larger radius due to the bending arc length of the flexible display being larger than the bending arc length of the flexible chassis). In such an example, the hinge can slide laterally along guides as the electronic device is bent to accommodate the additional arc length of the flexible chassis relative to the flexible display as the electronic device approaches a closed configuration or to accommodate the reduced arc length of the flexible chassis relative to the flexible display as the electronic device approaches a tablet configuration.

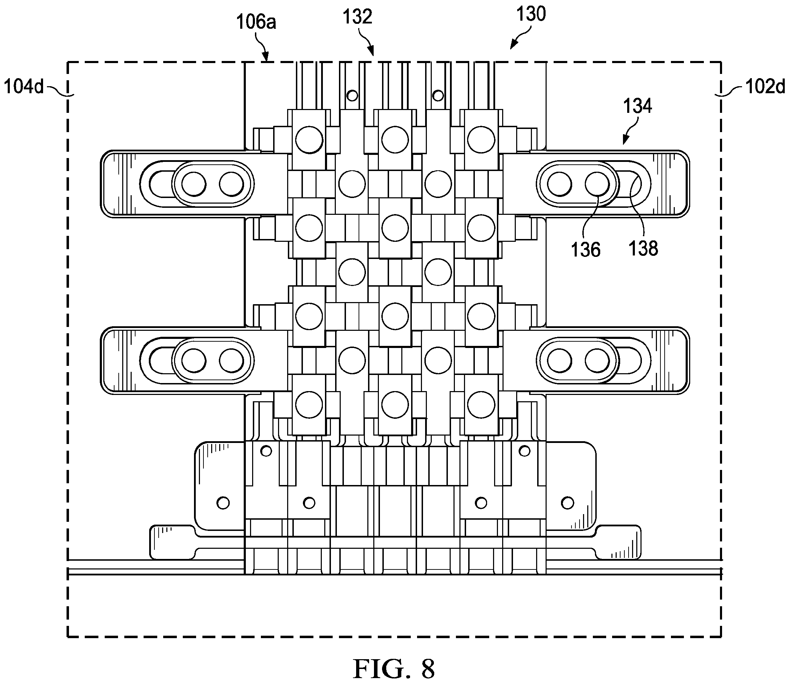

The flexible display support can provide support for the flexible display, drive the length of the flexible chassis, and help the flexible display retain an even shape or profile as the electronic device is bent. In some examples, the flexible display support is attached to the flexible display by flexible display adhesive and can drive the length of the flexible chassis. The hinge can slide laterally along guides as the flexible display and flexible chassis are bent. The hinge can be coupled to the flexible display support by an adhesive and a membrane material. In a specific example, the hinge can allow for the additional arc length of the flexible chassis relative to the flexible display as the electronic device approaches a closed configuration or the reduced arc length of the flexible chassis relative to the flexible display as the electronic device approaches a tablet configuration via slide guides which are rigidly coupled to the hinge components but have an open degree of freedom relative to the flexible chassis. The interaction of the slide guides and slide guide pins (e.g., chassis securing means 136 illustrated in FIGURE 8), which are coupled to the flexible chassis, control the telescoping motion of the hinge to accommodate the change in the position of the flexible chassis relative to the flexible display. The hinge can be comprised of hinge components such as watch band components, friction elements, etc.

In an example, a counterforce band or bands can be configured to help bend the flexible chassis and to help drive the flexible chassis to expand. The counterforce band(s) can be bent so that the band(s) are in their natural shape when the electronic device is in a closed configuration. The counterforce band(s) can be configured to generate a counterforce that tries to close the electronic device while the flexible display support tries to open the electronic device. Depending on the desired functionality, the counterforce band can be designed to reduce or eliminate forces from the flexible display support (e.g., spring shape and size, material, thickness, etc.). In some examples, shape memory alloys may be used for additional functions (e.g. automatic opening or closing) or improved usability (assisting a user in opening or closing).

In another example, a self-straightening band can be configured to help the flexible display and flexible chassis lay flat or convert to a flat configuration. Other examples include separating the self-straightening band and configuring it to be a separate design element to further improve or intensify the self-straightening of the electronic device. In some examples, the flexible display will also be supported from the bending area. The self-straightening band can also provide a self-straightening feature that acts as a lay-flat locking mechanism. The hinge of the electronic device can be designed so that it does not necessarily need synchronization gears, but in some examples, the hinge can include synchronization elements or features.

In an example implementation, electronic devices 100a and 100b are meant to encompass a computer, a personal digital assistant (PDA), a laptop or electronic notebook, a cellular telephone, an iPhone, an IP phone, or any other device, component, element, or object that includes a flexible display. Electronic devices 100a and 100b may include any suitable hardware, software, components, modules, or objects that facilitate the operations thereof, as well as suitable interfaces for receiving, transmitting, and/or otherwise communicating data or information in a network environment. This may be inclusive of appropriate algorithms and communication protocols that allow for the effective exchange of data or information. Electronic devices 100a and 100b may include virtual elements.

In regards to the internal structure associated with electronic devices 100a and 100b, electronic devices 100a and 100b can include memory elements for storing information to be used in operations or functions. Electronic devices 100a and 100b may keep information in any suitable memory element (e.g., random access memory (RAM), read-only memory (ROM), erasable programmable ROM (EPROM), electrically erasable programmable ROM (EEPROM), application specific integrated circuit (ASIC), etc.), software, hardware, firmware, or in any other suitable component, device, element, or object where appropriate and based on particular needs. Any of the memory items discussed herein should be construed as being encompassed within the broad term 'memory element.' Moreover, the information being used, tracked, sent, or received in electronic devices 100a and 100b could be provided in any database, register, queue, table, cache, control list, or other storage structure, all of which can be referenced at any suitable timeframe. Any such storage options may also be included within the broad term 'memory element' as used herein.

In certain example implementations, functions may be implemented by logic encoded in one or more tangible media (e.g., embedded logic provided in an ASIC, digital signal processor (DSP) instructions, software (potentially inclusive of object code and source code) to be executed by a processor, or other similar machine, etc.), which may be inclusive of non-transitory computer-readable media. In some of these instances, memory elements can store data used for the operations described herein. This includes the memory elements being able to store software, logic, code, or processor instructions that are executed to carry out the activities.

Additionally, electronic devices 100a and 100b may include one or more processors that can execute software or an algorithm to perform activities. A processor can execute any type of instructions associated with the data to achieve one or more operations. In one example, the processors could transform an element or an article (e.g., data) from one state or thing to another state or thing. In another example, the activities outlined herein may be implemented with fixed logic or programmable logic (e.g., software/computer instructions executed by a processor) and electronic devices 100a and 100b could include some type of a programmable processor, programmable digital logic (e.g., a field programmable gate array (FPGA), an erasable programmable read-only memory (EPROM), an electrically erasable programmable read-only memory (EEPROM)) or an ASIC that includes digital logic, software, code, electronic instructions, or any suitable combination thereof. Any of the potential processing elements and modules described herein should be construed as being encompassed within the broad term 'processor.'

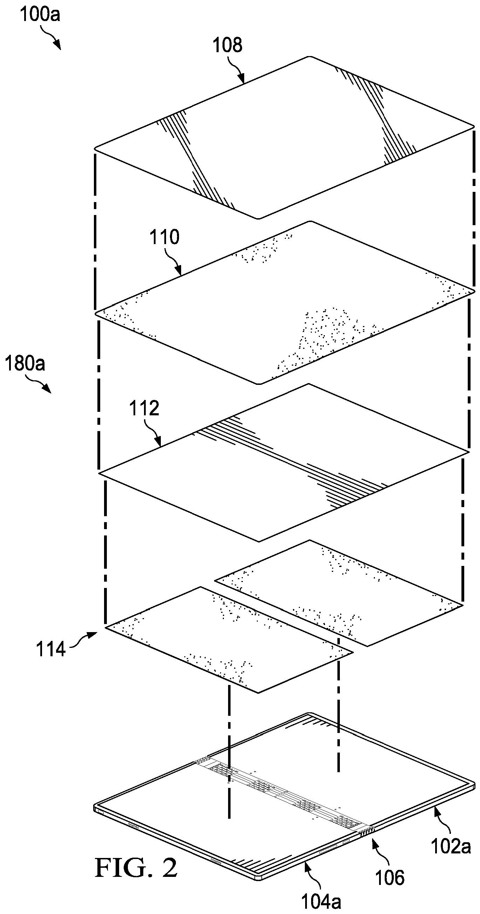

Turning to FIGURE 2, FIGURE 2 is a simplified block diagram of an exploded view of electronic device 100a. In an example, electronic device 100a can include flexible display 108 and chassis 180a. Chassis 180a can include first portion chassis 102a, second portion chassis 104a, hinge 106, and a flexible display support 112. An adhesive layer 110 can help couple flexible display 108 to flexible display support 112. An adhesive padding 114 can help couple flexible display support 112 to first portion chassis 102a and second portion chassis 104a.

Flexible display support 112 may be comprised of Nitinol, titanium, spring steel, carbon fiber, glass fiber, an elastic non-stretchable composite, or some other similar material that can provide both rigid and flexible support for flexible display 108. Adhesive layer 110 may be an adhesive, foam adhesive, pressure sensitive adhesive (PSA), or some other material that can help secure flexible display 108 to flexible display support 112. Adhesive padding 114 may be an adhesive, foam adhesive, PSA, or some other material that can help secure flexible display support 112 to first portion chassis 102a and second portion chassis 104a.

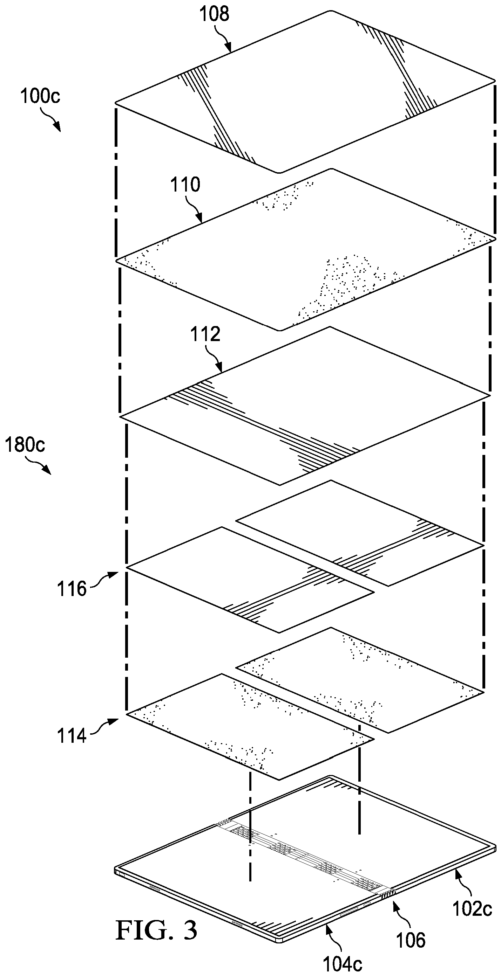

Turning to FIGURE 3, FIGURE 3 is a simplified block diagram of an exploded view of electronic device 100c. In an example, electronic device 100c can include flexible display 108 and a chassis 180c. Chassis 180c can include a first portion chassis 102c, a second portion chassis 104c, hinge 106, flexible display support 112, and a sliding display frame 116. Adhesive layer 110 can help couple flexible display 108 to flexible display support 112. Adhesive padding 114 can help couple sliding display frame 116 to first portion chassis 102c and second portion chassis 104c. Sliding display frame 116 can be configured to accommodate the difference and/or change in the position of chassis 180c relative to flexible display 108 as electronic device 100c is bent.

Turning to FIGURE 4, FIGURE 4 is a simplified block diagram of sliding display frame 116. Sliding display frame 116 includes one or more display slide mechanisms 118. A flexible display support (e.g., flexible display support 112) can be coupled to one or more display slide mechanisms 118. To accommodate the difference and/or change in the position of chassis 180c (not shown) relatively to flexible display 108 (not shown), flexible display support 112 can slide on one or more display slide mechanisms 118. In an example, one or more display slide mechanisms 118 can be the located in a proximate middle portion of sliding display frame 116 and electronic device 100c. In another example, one or more display slide mechanisms 118 can be the located on one or more sides of sliding display frame 116 and electronic device 100c.

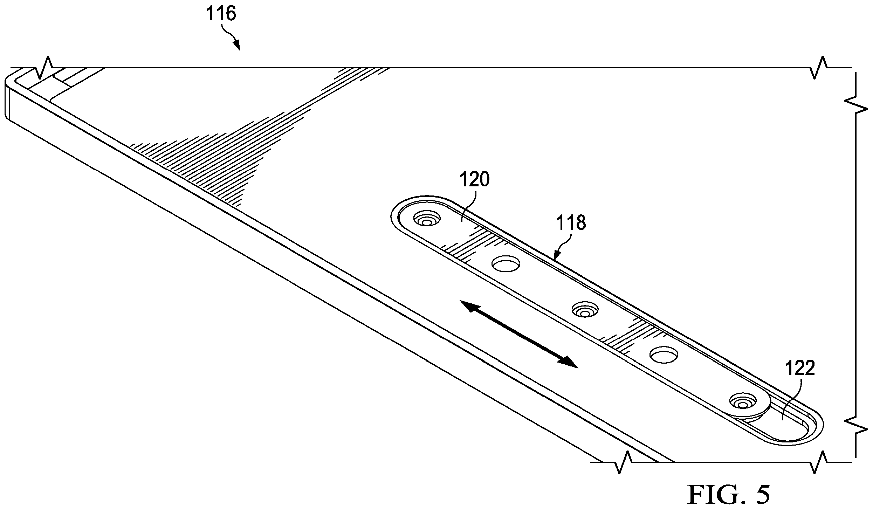

Turning to FIGURE 5, FIGURE 5 is a simplified block diagram of a portion of sliding display frame 116. In an example, sliding display frame 116 can include one or more display slide mechanisms 118. Each display slide mechanism 118 can include a display slide 120 and a display slide channel 122. Display slide 120 can be coupled to flexible display support 112 (not shown) and is configured to slide or move along display slide channel 122. The movement along display slide channel 122 can help chassis 180c accommodate the difference and/or change in the position of chassis 180c (not shown) relatively to flexible display 108 (not shown), as flexible display 108 is bent.

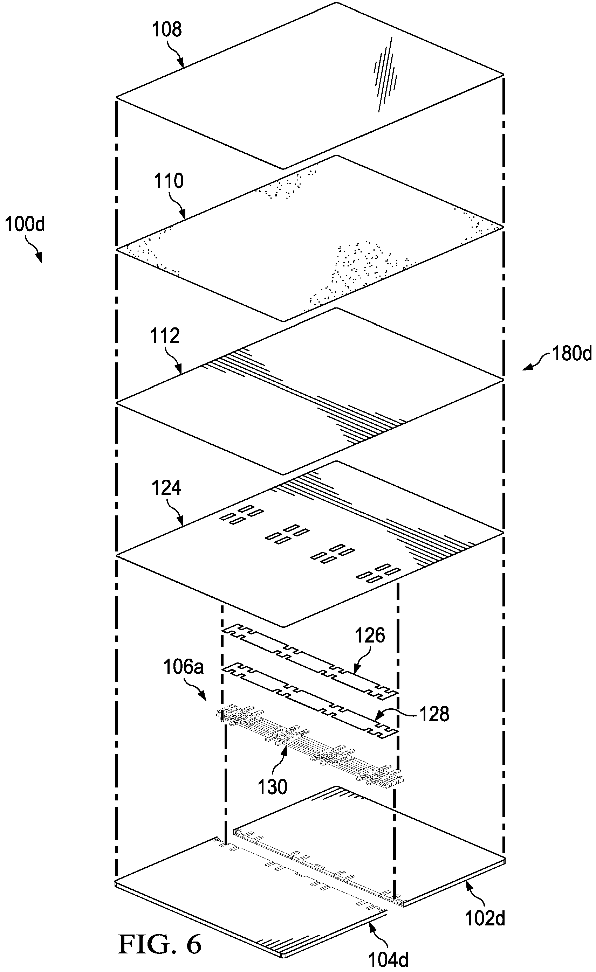

Turning to FIGURE 6, which is not encompassed by the wording of the claims but are considered as useful for understanding the invention, FIGURE 6 is a simplified block diagram of an exploded view of electronic device 100d. In an example, electronic device 100d can include flexible display 108 and a chassis 180d. Chassis 180d can include a first portion chassis 102d, a second portion chassis 104d, a hinge 106a, flexible display support 112, and a bonding layer 124. Adhesive layer 110 can help couple flexible display 108 to flexible display support 112.

Hinge 106a can include a membrane material 126 and an expandable hinge assembly 130. An adhesive 128 can help secure membrane material 126 to expandable hinge assembly 130. Bonding layer 124 can help couple flexible display support 112 to membrane material 126 in hinge 106a. Hinge 106a can be configured to allow for movement of first portion chassis 102d and second portion chassis 104d. Bonding layer 124 can be a PSA or some other bonding or adhesive material that can couple flexible display support 112 to membrane material 126 in hinge 106a. Membrane material 126 may be an elastomer, rubber, or some other coupling material that can couple expandable hinge assembly 130 to flexible display support 112 and allow electronic device 100d to accommodate the difference and/or change in the position of chassis 180d relative to flexible display 108 as electronic device 100d is bent. Adhesive 128 can be a PSA or some other bonding or adhesive material that can couple membrane material 126 to expandable hinge assembly 130.

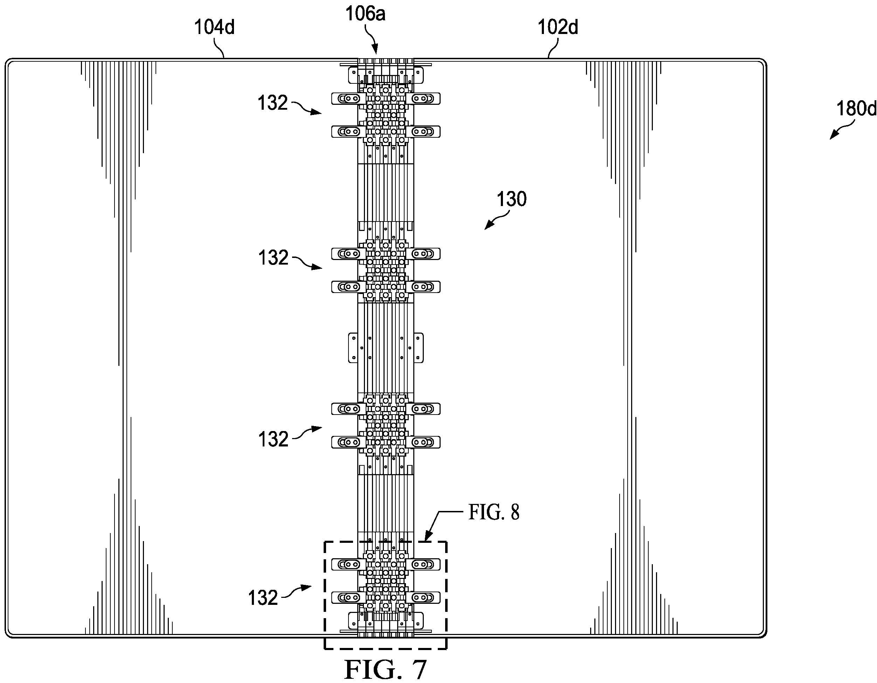

Turning to FIGURE 7, which is not encompassed by the wording of the claims but are considered as useful for understanding the invention, FIGURE 7 is a simplified block diagram of a portion of chassis 180d. Hinge 106a can be configured to couple and allow for movement of first portion chassis 102d and second portion chassis 104d. Hinge 106a can include one or more expandable hinge assemblies 130. Each expandable hinge assembly 130 can include one or more expandable hinge chassis coupling 132. Expandable hinge chassis coupling 132 can help to couple hinge 106a to first portion chassis 102d and second portion chassis 104d to help accommodate the difference and/or change in position of chassis 180d relative to flexible display 108 (not shown).

Turning to FIGURE 8, FIGURE 8 is a simplified block diagram of a portion of hinge 106a. Hinge 106a can include expandable hinge assembly 130. Expandable hinge assembly 130 can include one or more expandable hinge chassis coupling 132. Expandable hinge chassis coupling 132 can include one or more chassis coupling tabs 134. In an example, one or more chassis coupling tabs 134 are located at a proximate middle portion of hinge 106a. In another example, one or more chassis coupling tabs 134 are located on one or both sides of hinge 106a. Each chassis coupling tab 134 can include a chassis securing means 136 and a chassis securing means channel 138. Chassis securing means 136 can be coupled to first portion chassis 102d and/or second portion chassis 104d. Chassis securing means 136 can slide or move along chassis securing means channel 138 to accommodate the difference and/or change in the position of chassis 180d (not shown) relative to flexible display 108 (not shown).

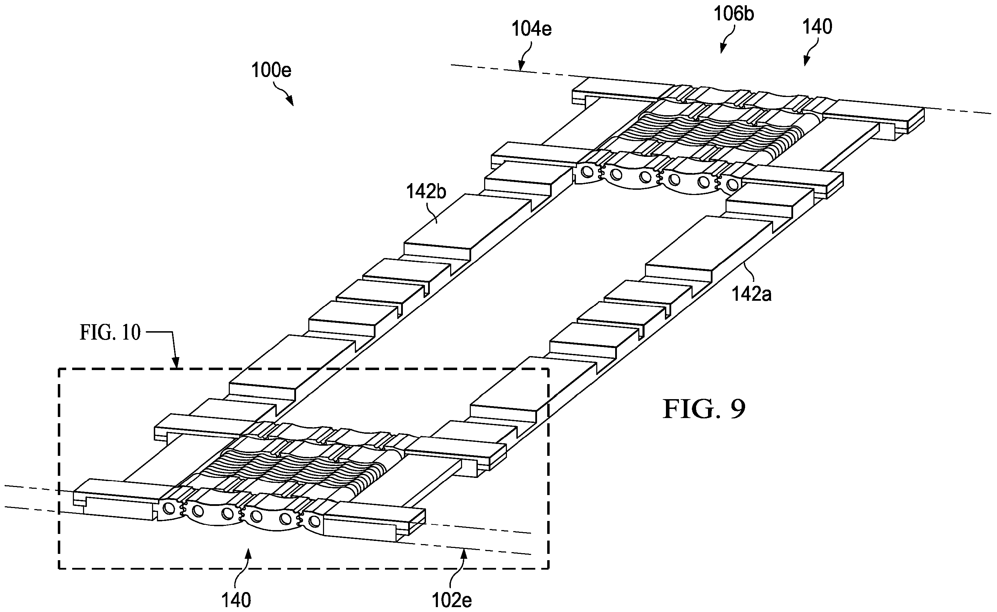

Turning to FIGURE 9, FIGURE 9 is a simplified block diagram of a portion of electronic device 100e. Electronic device 100e can include a first portion chassis 102e, a second portion chassis 104e, and a hinge 106b. Hinge 106b can include one or more hinge sections 140 and chassis couplers 142a and 142b. Chassis coupler 142a can be coupled to first portion chassis 102e and chassis coupler 142b can be coupled to second portion chassis 104e. Each of one or more hinge sections 140 allow chassis coupler 142a to rotate relative to chassis coupler 142b.

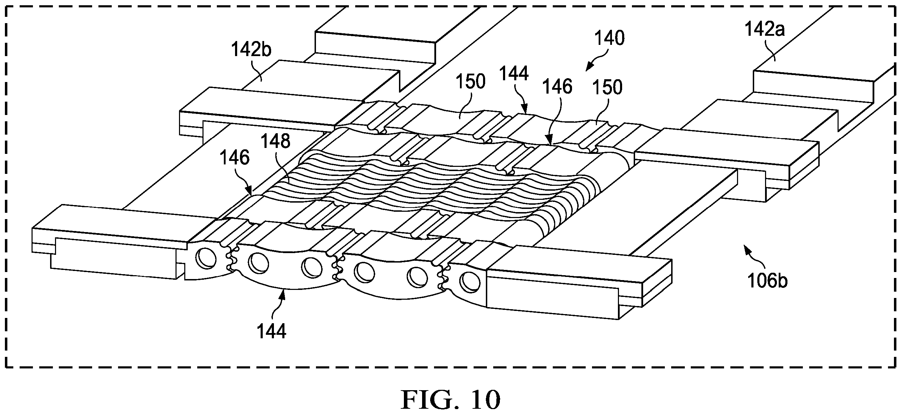

Turning to FIGURE 10, FIGURE 10 is a simplified block diagram of a portion of hinge 106b. Hinge 106b can include one or more hinge sections 140 and chassis couplers 142a and 142b. Each of one or more hinge sections 140 can include a first hinge link synchronizer row 144, a second hinge link synchronizer row 146, and friction plates 148. Friction plates 148 may be torque plates, frictions plates, or some other element that provides torque or friction during the rotation of hinge 106b. Each of first hinge link synchronizer row 144 and second hinge link synchronizer row 146 can include a plurality of synchronizing hinge links 150. When first portion chassis 102a is rotated relative to second portion chassis 104a, synchronizing hinge links 150 can help provide a uniform bending of hinge section 140.

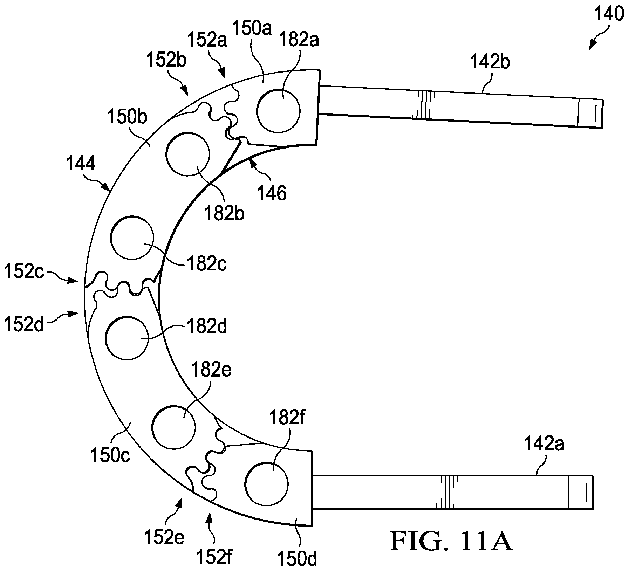

Turning to FIGURE 11A, FIGURE 11A is a simplified block diagram of a portion of hinge section 140. Hinge section 140 can include first hinge link synchronizer row 144, second hinge link synchronizer row 146, and rotation points 182a-182f. First hinge link synchronizer row 144 and second hinge link synchronizer row 146 can include synchronizing hinge links 150. For example, as illustrated in FIGURE 11A, first hinge link synchronizer row 144 includes synchronizing hinge links 150a-150d. Each of synchronizing hinge links 150 can include a plurality of teeth. For example, as illustrated in FIGURE 11A, synchronizing hinge link 150a includes teeth 152a, synchronizing hinge link 150b includes teeth 152b and 152c, synchronizing hinge link 150c includes teeth 152d and 152e, and synchronizing hinge link 150d includes teeth 152f.

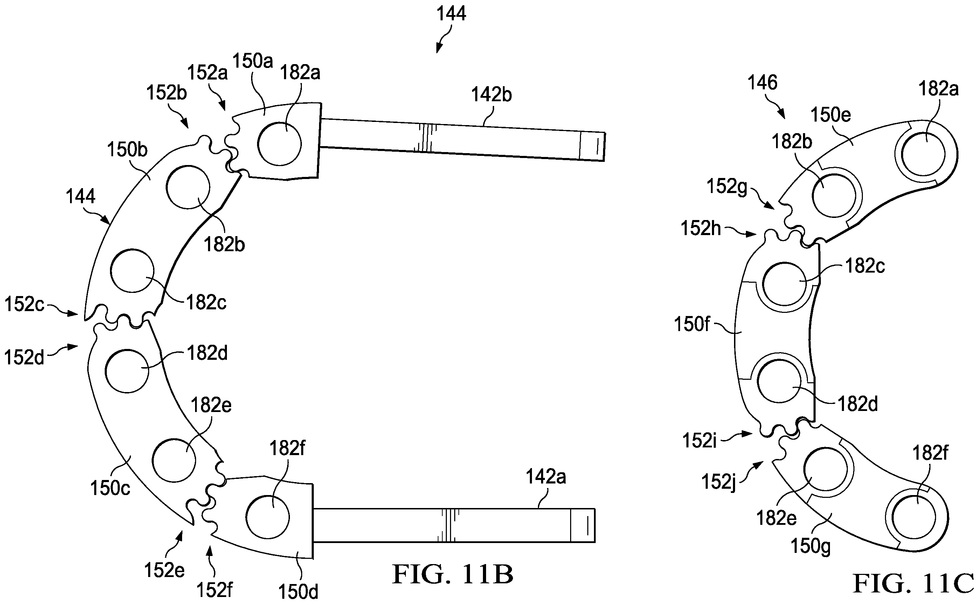

Turning to FIGURE 11B, FIGURE 11B is a simplified block diagram of first hinge link synchronizer row 144. First hinge link synchronizer row 144 includes synchronizing hinge links 150a-150d. Synchronizing hinge link 150a can include rotation point 182a, synchronizing hinge link 150b can include rotation points 182b and 182c, synchronizing hinge link 150c can include rotation points 182d and 182e, and synchronizing hinge link 150d can include rotation point 182f. Each of synchronizing hinge links 150a-150d can include a plurality of teeth. For example, as illustrated in FIGURE 11B, synchronizing hinge link 150a includes teeth 152a, synchronizing hinge link 150b includes teeth 152b and 152c, synchronizing hinge link 150c includes teeth 152d and 152e, and synchronizing hinge link 150d includes teeth 152f. Teeth 152a of synchronizing hinge link 150a mesh with teeth 152b of synchronizing hinge link 150b, teeth 152c of synchronizing hinge link 150b mesh with teeth 152d of synchronizing hinge link 150c, and teeth 152e of synchronizing hinge link 150c mesh with teeth 152f of synchronizing hinge link 150d.

Turning to FIGURE 11C, FIGURE 11C is a simplified block diagram of second hinge link synchronizer row 146. Second hinge link synchronizer row 146 includes synchronizing hinge links 150e-150g. Synchronizing hinge link 150e can include rotation points 182a and 182b, synchronizing hinge link 150f can include rotation points 182c and 182d, and synchronizing hinge link 150g can include rotation points 182e and 182f. Each of synchronizing hinge links 150e-150g can include a plurality of teeth. For example, as illustrated in FIGURE 11C, synchronizing hinge link 150e includes teeth 152g, synchronizing hinge link 150f includes teeth 152h and 152i, and synchronizing hinge link 150g includes teeth 152j. Teeth 152g of synchronizing hinge link 150e mesh with teeth 152h of synchronizing hinge link 150f and teeth 152i of synchronizing hinge link 150f mesh with teeth 152j of synchronizing hinge link 150g.

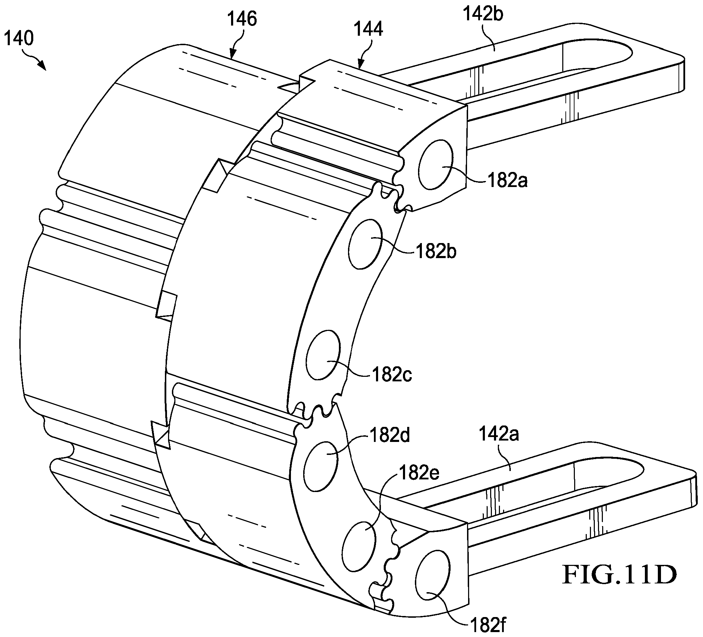

Turning to FIGURE 11D, FIGURE 11D is a simplified block diagram of a portion of hinge section 140. Hinge section 140 can include first hinge link synchronizer row 144, second hinge link synchronizer row 146, and rotation points 182a-182f. First hinge link synchronizer row 144 and second hinge link synchronizer row 146 can include synchronizing hinge links 150.

When chassis coupler 142a is rotated relative to chassis coupler 142b, teeth of a synchronizing hinge link mesh with teeth of a neighboring synchronizing hinge link to help provide a uniform bending of hinge section 140. For example, as illustrated in FIGURE 11B, when chassis coupler 142a is rotated relative to chassis coupler 142b, teeth 152a of synchronizing hinge link 150a can mesh with teeth 152b of synchronizing hinge link 150b to help provide a uniform bending of hinge section 140.

With respect to first hinge link synchronizer row 144, synchronizing hinge link 150a can include rotation point 182a, synchronizing hinge link 150b can include rotation points 182b and 182c, synchronizing hinge link 150c can include rotation points 182d and 182e, and synchronizing hinge link 150d can include rotation point 182f and with respect to second hinge link synchronizer row 146, synchronizing hinge link 150e can include rotation points 182a and 182b, synchronizing hinge link 150f can include rotation points 182c and 182d, and synchronizing hinge link 150g can include rotation points 182e and 182f. Using teeth 152a-152f, first hinge link synchronizer row 144 can synchronize rotation about rotation points 182a and 182b, about rotation points 182c and 182d, and about rotation points 182e and 182f using teeth 152g-152j, and second hinge link synchronizer row 146 can synchronize rotation about rotation points 182b and 182c and about rotation points 182d and 182e to create full synchronization of the bending or rotation of hinge section 140 and to help provide a uniform bending of hinge section 140.

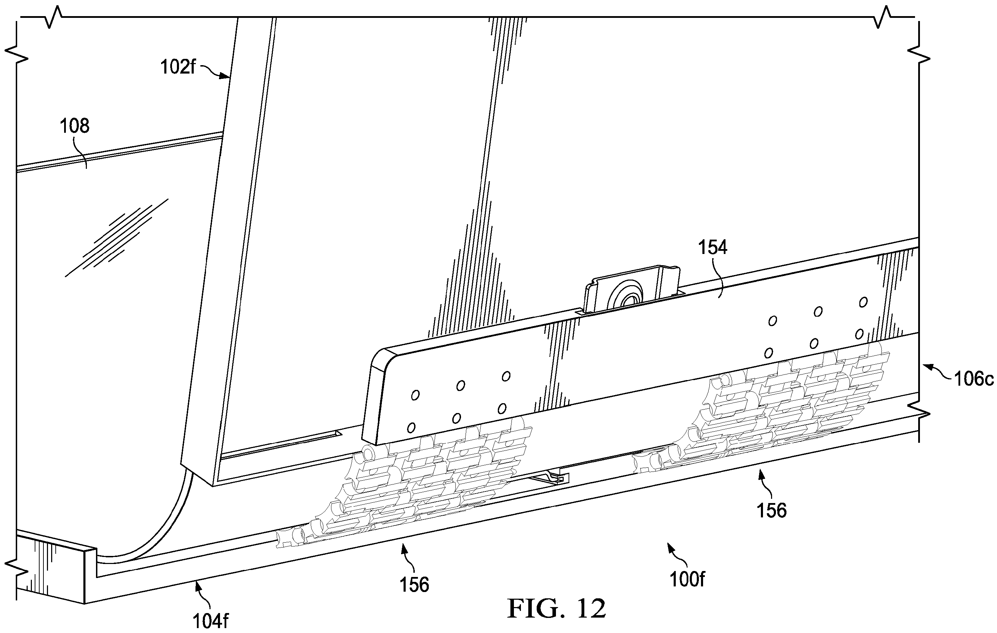

Turning to FIGURE 12, FIGURE 12 is a simplified block diagram of a portion of an electronic device 100f. Electronic device 100f can include to a first portion chassis 102f, a second portion chassis 104f, a hinge 106c, and flexible display 108. Hinge 106c can include a hinge frame 154 and one or more hinge links 156. Hinge frame 154 can help couple hinge 106c to first portion chassis 102f and second portion chassis 104f. Each of one or more hinge links 156 allow first portion chassis 102f to rotate relative to second portion chassis 104f.

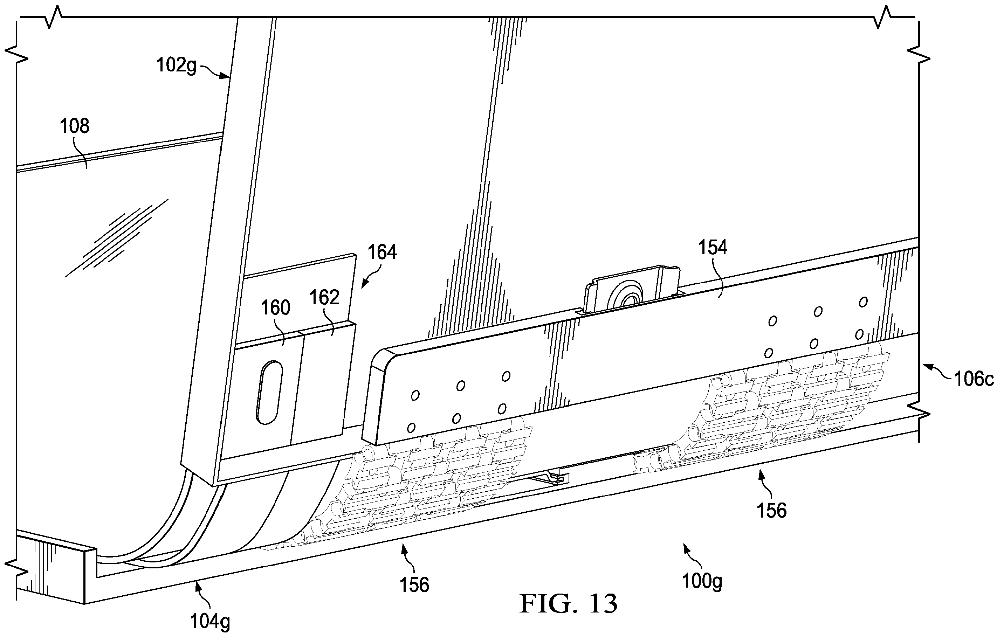

Turning to FIGURE 13, FIGURE 13 is a simplified block diagram of a portion of electronic device 100g. Electronic device 100g can include a first portion chassis 102g, a second portion chassis 104g, a hinge 106c, flexible display 108, a counterforce band 160, a self-straightening band 162, and a chassis movement accommodation channel 164. Counterforce band 160 can be configured to help bend electronic device 100g. Self-straightening band 162 can be configured to help electronic device 100g lay flat. Chassis movement accommodation channel 164 can help to accommodate changes in length of electronic device 100g as flexible display 108 is bent. In some examples, only counterforce band 160 is included in electronic device 100g. In other examples, only self-straightening band 162 is included in electronic device 100g.

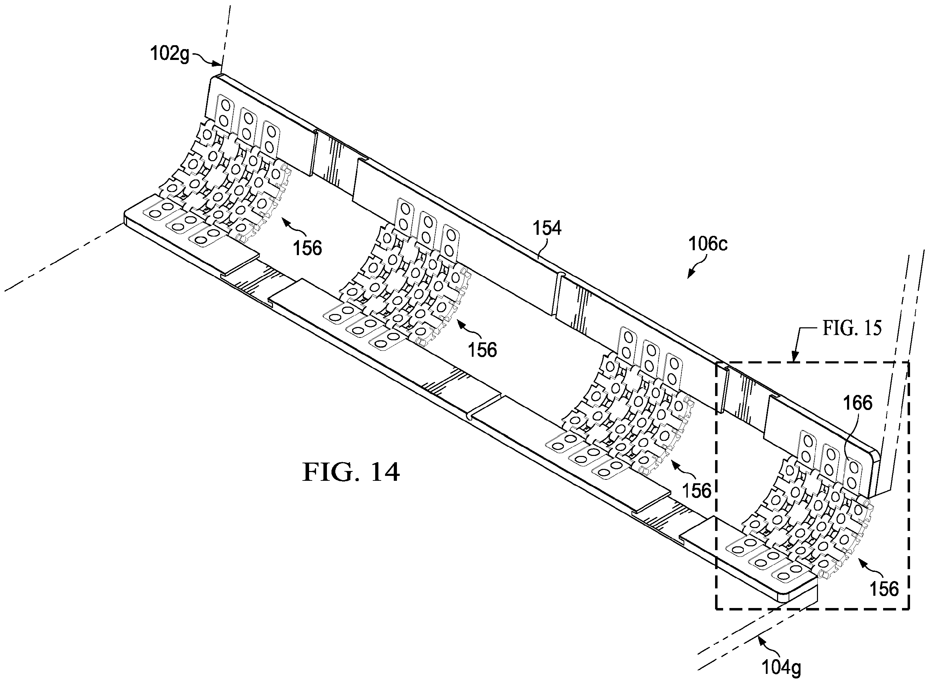

Turning to FIGURE 14, FIGURE 14 is a simplified block diagram of hinge 106c. Hinge 106c can include hinge frame 154 and one or more hinge links 156. Hinge links 156 can include one or more hinge arms 166 that are coupled to hinge frame 154.

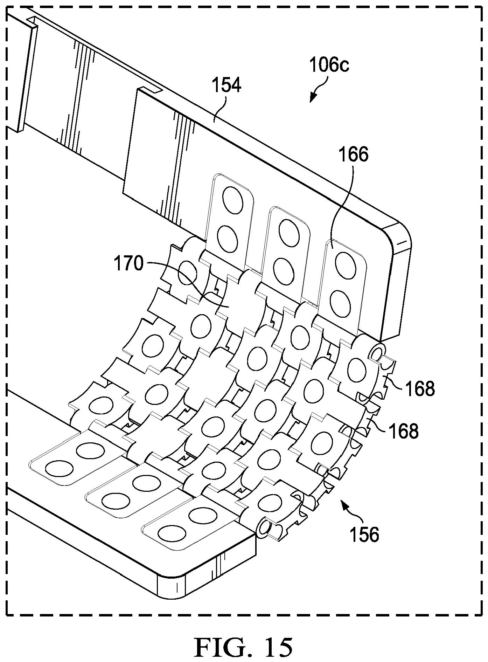

Turning to FIGURE 15, FIGURE 15 is a simplified block diagram of a portion of hinge 106c. Hinge 106c can include hinge frame 154 and one or more hinge links 156. Each of one or more hinge links 156 can include one or more hinge arms 166 and a plurality of links 168. In some examples, each of one or more hinge links 156 can include one or more friction elements 170. One or more friction elements 170 can be configured to provide resistance when flexible display is bent and can help flexible display 108 remain in a position set by a user.

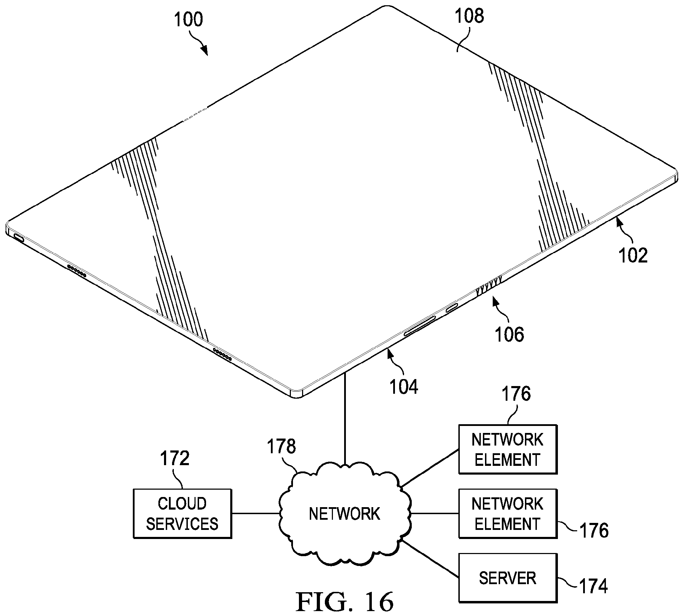

Turning to FIGURE 16, FIGURE 16 is a simplified block diagram of a portion of an electronic device 100. Electronic device 100 includes first portion chassis 102, second portion chassis 104, hinge 106, and flexible display 108. Electronic device 100 may be in communication with cloud services 172, one or more servers 174, and/or one or more network elements 176 using network 178. In some examples, electronic device 100 may be standalone devices and not connected to network 178 or another device.

Elements of FIGURE 16 may be coupled to one another through one or more interfaces employing any suitable connections (wired or wireless), which provide viable pathways for network (e.g., network 178, etc.) communications. Additionally, any one or more of these elements of FIGURE 16 may be combined or removed from the architecture based on particular configuration needs. Network 178 may include a configuration capable of transmission control protocol/Internet protocol (TCP/IP) communications for the transmission or reception of packets in a network. Electronic devices 100 may also operate in conjunction with a user datagram protocol/IP (UDP/IP) or any other suitable protocol where appropriate and based on particular needs.

Turning to the infrastructure of FIGURE 16, network 178 represents a series of points or nodes of interconnected communication paths for receiving and transmitting packets of information. Network 178 offers a communicative interface between nodes, and may be configured as any local area network (LAN), virtual local area network (VLAN), wide area network (WAN), wireless local area network (WLAN), metropolitan area network (MAN), Intranet, Extranet, virtual private network (VPN), and any other appropriate architecture or system that facilitates communications in a network environment, or any suitable combination thereof, including wired and/or wireless communication.

In network 178, network traffic, which is inclusive of packets, frames, signals, data, etc., can be sent and received according to any suitable communication messaging protocols. Suitable communication messaging protocols can include a multi-layered scheme such as Open Systems Interconnection (OSI) model, or any derivations or variants thereof (e.g., Transmission Control Protocol/Internet Protocol (TCP/IP), user datagram protocol/IP (UDP/IP)). Messages through the network could be made in accordance with various network protocols, (e.g., Ethernet, Infiniband, OmniPath, etc.). Additionally, radio signal communications over a cellular network may also be provided. Suitable interfaces and infrastructure may be provided to enable communication with the cellular network.

The term "packet" as used herein, refers to a unit of data that can be routed between a source node and a destination node on a packet switched network. A packet includes a source network address and a destination network address. These network addresses can be Internet Protocol (IP) addresses in a TCP/IP messaging protocol. The term "data" as used herein, refers to any type of binary, numeric, voice, video, textual, or script data, or any type of source or object code, or any other suitable information in any appropriate format that may be communicated from one point to another in electronic devices and/or networks.

Although the present invention has been described in detail with reference to particular arrangements and configurations, these example configurations and arrangements may be changed significantly without departing from the scope of the present invention. Moreover, certain components may be combined, separated, eliminated, or added based on particular needs and implementations. Additionally, although electronic devices 100a-100g have been illustrated with reference to particular elements and operations that facilitate the communication process, these elements and operations may be replaced by any suitable architecture, protocols, and/or processes that achieve the intended functionality of electronic device 100.

## Claims

1. An electronic device comprising:
a flexible display (108), wherein the flexible display (108) has a display length;
a hinge; and
a chassis (180a; 180b), wherein the chassis (180a; 180b) has a chassis length, wherein the chassis (180a; 180b) includes:
a first portion chassis (102) and a second portion chassis (104), wherein the first portion chassis (102) and the second portion chassis (104) provide a relatively flat and uniform surface for the flexible display (108);
a flexible display support (112) coupled to the flexible display (108), the flexible display support (112) being configured to produce a self-straightening action in a flat configuration; and
a sliding display frame (116) coupled to the first portion chassis (102) and the second portion chassis (104) by means of an adhesive padding (114), the sliding display frame (116) including one or more slide mechanisms (118) to accommodate a difference of the chassis length relative to the display length as the electronic device (100) is bent, wherein each of the one or more slide mechanisms (118) includes:
a display slide (120) coupled to the flexible display support (112); and
a display slide channel (122), wherein the display slide (120) can move along the display slide channel (122) to accommodate the difference of the chassis length relative to the display length as the electronic device (100) is bent.

2. The electronic device of Claim 1, wherein the one or more slide mechanisms (118) are located in a proximate middle portion of the electronic device (100).

3. The electronic device of any one of Claims 1-2, wherein the one or more slide mechanisms (118) are located on one or more sides of the electronic device (100).

4. The electronic device of any one of Claims 1-3, wherein the chassis further includes:
a counterforce band (160).

5. The electronic device of any one of Claims 1-4, wherein the chassis further includes:
a self-straightening band (162).

6. The electronic device of any one of Claims 1-5, wherein the flexible display (108) is a foldable organic light emitting diode, FOLED, display.

7. A method comprising:
bending an electronic device (100) about a hinge (106), wherein the electronic device (106) includes:
a flexible display (108), wherein the flexible display (108) has a display length; and
a chassis (180a; 180b), wherein the chassis (180a; 180b) has a chassis length and is coupled to the flexible display (108) by the hinge (106), wherein the chassis (180a; 180b) includes:
a first portion chassis (102) and a second portion chassis (104), wherein the first portion chassis (102) and the second portion chassis (104) provide a relatively flat and uniform surface for the flexible display (108);
a flexible display support (112) coupled to the flexible display (108), the flexible display support (112) being configured to produce a self-straightening action in a flat configuration; and
a sliding display frame (116) coupled to the first portion chassis (102) and the second portion chassis (104) by means of an adhesive padding (114), the sliding display frame (116) including one or more slide mechanisms (118) to accommodate a difference of the chassis length relative to the display length as the electronic device (100) is bent about the hinge (106), wherein each of the one or more slide mechanisms (118) includes:
a display slide (120) coupled to the flexible display support (112); and
a display slide channel (122), wherein the display slide (120) can move along the display slide channel (122) to accommodate the difference of the chassis length relative to the display length as the electronic device (100) is bent.

8. The method of Claim 7, wherein the chassis further includes: a counterforce band (160).

9. The method of any one of Claims 7-8, wherein the chassis further includes: a self-straightening band (162).

10. The method of any one of Claims 7-9, wherein the flexible display (118) is a foldable organic light emitting diode, FOLED, display.

## Patentansprüche

1. Elektronische Vorrichtung, die Folgendes umfasst:
eine flexible Anzeige (108), wobei die flexible Anzeige (108) eine Anzeigelänge aufweist;
ein Scharnier; und
ein Chassis (180a; 180b), wobei das Chassis (180a; 180b) eine Chassislänge aufweist, wobei das Chassis (180a; 180b) Folgendes enthält:
ein erstes Teilchassis (102) und ein zweites Teilchassis (104), wobei das erste Teilchassis (102) und das zweite Teilchassis (104) eine relativ flache und einheitliche Oberfläche für die flexible Anzeige (108) bereitstellen;
einen flexiblen Anzeigeträger (112), der mit der flexiblen Anzeige (108) gekoppelt ist, wobei der flexible Anzeigeträger (112) so ausgebildet ist, dass eine selbst geraderichtende Aktion in einer flachen Konfiguration hervorgerufen wird; und
einen gleitenden Anzeigerahmen (116), der mittels einer Klebepolsterung (114) mit dem ersten Teilchassis (102) und dem zweiten Teilchassis (104) gekoppelt ist, wobei der gleitende Anzeigerahmen (116) einen oder mehrere Gleitmechanismen (118) enthält, um einen Unterschied der Chassislänge relativ zu der Anzeigelänge auszugleichen, wenn die elektronische Vorrichtung (100) gebogen wird, wobei jeder des einen oder der mehreren Gleitmechanismen (118) Folgendes enthält:
ein Anzeigegleitstück (120), das mit dem flexiblen Anzeigeträger (112) gekoppelt ist; und
einen Anzeigegleitkanal (122), wobei sich das Anzeigegleitstück (120) entlang des Anzeigegleitkanals (122) bewegen kann, um den Unterschied der Chassislänge relativ zu der Anzeigelänge auszugleichen, wenn die elektronische Vorrichtung (100) gebogen wird.

2. Elektronische Vorrichtung nach Anspruch 1, wobei sich der eine oder die mehreren Gleitmechanismen (118) in einem nahen mittleren Teil der elektronischen Vorrichtung (100) befinden.

3. Elektronische Vorrichtung nach einem der Ansprüche 1-2, wobei sich der eine oder die mehreren Gleitmechanismen (118) auf einer oder mehreren Seiten der elektronischen Vorrichtung (100) befinden.

4. Elektronische Vorrichtung nach einem der Ansprüche 1-3, wobei das Chassis ferner Folgendes enthält:
ein Gegenkraftband (160).

5. Elektronische Vorrichtung nach einem der Ansprüche 1-4, wobei das Chassis ferner Folgendes enthält:
ein selbst geraderichtendes Band (162).

6. Elektronische Vorrichtung nach einem der Ansprüche 1-5, wobei die flexible Anzeige (108) eine Foldable-Organic-Light-Emitting-Diode-Anzeige, FOLED-Anzeige, ist.

7. Verfahren, das Folgendes umfasst:
Biegen einer elektronischen Vorrichtung (100) um ein Scharnier (106), wobei die elektronische Vorrichtung (106) Folgendes enthält:
eine flexible Anzeige (108), wobei die flexible Anzeige (108) eine Anzeigelänge aufweist; und
ein Chassis (180a; 180b), wobei das Chassis (180a; 180b) eine Chassislänge aufweist und über das Scharnier (106) mit der flexiblen Anzeige (108) gekoppelt ist, wobei das Chassis (180a; 180b) Folgendes enthält:
ein erstes Teilchassis (102) und ein zweites Teilchassis (104), wobei das erste Teilchassis (102) und das zweite Teilchassis (104) eine relativ flache und einheitliche Oberfläche für die flexible Anzeige (108) bereitstellen;
einen flexiblen Anzeigeträger (112), der mit der flexiblen Anzeige (108) gekoppelt ist, wobei der flexible Anzeigeträger (112) so ausgebildet ist, dass eine selbst geraderichtende Aktion in einer flachen Konfiguration hervorgerufen wird; und
einen gleitenden Anzeigerahmen (116), der mittels einer Klebepolsterung (114) mit dem ersten Teilchassis (102) und dem zweiten Teilchassis (104) gekoppelt ist, wobei der gleitende Anzeigerahmen (116) einen oder mehrere Gleitmechanismen (118) enthält, um einen Unterschied der Chassislänge relativ zu der Anzeigelänge auszugleichen, wenn die elektronische Vorrichtung (100) um das Scharnier (106) gebogen wird, wobei jeder des einen oder der mehreren Gleitmechanismen (118) Folgendes enthält:
ein Anzeigegleitstück (120), das mit dem flexiblen Anzeigeträger (112) gekoppelt ist; und
einen Anzeigegleitkanal (122), wobei sich das Anzeigegleitstück (120) entlang des Anzeigegleitkanals (122) bewegen kann, um den Unterschied der Chassislänge relativ zu der Anzeigelänge auszugleichen, wenn die elektronische Vorrichtung (100) gebogen wird.

8. Verfahren nach Anspruch 7, wobei das Chassis ferner Folgendes enthält:
ein Gegenkraftband (160).

9. Verfahren nach einem der Ansprüche 7-8, wobei das Chassis ferner Folgendes enthält:
ein selbst geraderichtendes Band (162).

10. Verfahren nach einem der Ansprüche 7-9, wobei die flexible Anzeige (118) eine Foldable-Organic-Light-Emitting-Diode-Anzeige, FOLED-Anzeige, ist.

## Revendications

1. Dispositif électronique, comprenant :
un écran d'affichage flexible (108), dans lequel l'écran d'affichage flexible (108) a une longueur d'écran d'affichage ;
une charnière ; et
un châssis (180a ; 180b), dans lequel le châssis (180a ; 180b) a une longueur de châssis, dans lequel le châssis (180a ; 180b) inclut :
une première partie de châssis (102) et une seconde partie de châssis (104), dans lequel la première partie de châssis (102) et la seconde partie de châssis (104) fournissent une surface relativement plate et uniforme pour l'écran d'affichage flexible (108) ;
un support d'écran d'affichage flexible (112) couplé à l'écran d'affichage flexible (108), le support d'écran d'affichage flexible (112) étant configuré pour produire une action d'auto-redressement dans une configuration plate ; et
un cadre d'écran d'affichage coulissant (116) couplé à la première partie de châssis (102) et à la seconde partie de châssis (104) au moyen d'un tampon adhésif (114), le cadre d'écran d'affichage coulissant (116) incluant un ou plusieurs mécanismes de coulisseau (118) pour s'adapter à une différence de la longueur de châssis relativement à la longueur d'écran d'affichage quand le dispositif électronique (100) est plié, dans lequel chacun de l'un ou des plusieurs mécanismes de coulisseau (118) inclut :
un coulisseau d'écran d'affichage (120) couplé au support d'écran d'affichage flexible (112) ; et
une gorge de coulisseau d'écran d'affichage (122), dans lequel le coulisseau d'écran d'affichage (120) peut se déplacer le long de la gorge de coulisseau d'écran d'affichage (122) pour s'adapter à la différence de la longueur de châssis relativement à la longueur d'écran d'affichage quand le dispositif électronique (100) est plié.

2. Dispositif électronique de la revendication 1, dans lequel l'un ou les plusieurs mécanismes de coulisseau (118) sont situés dans une partie médiane proximale du dispositif électronique (100).

3. Dispositif électronique de l'une quelconque des revendications 1 et 2, dans lequel l'un ou les plusieurs mécanismes de coulisseau (118) sont situés sur un ou plusieurs côtés du dispositif électronique (100).

4. Dispositif électronique de l'une quelconque des revendications 1 à 3, dans lequel le châssis en outre inclut :
une bande de contre-force (160).

5. Dispositif électronique de l'une quelconque des revendications 1 à 4, dans lequel le châssis en outre inclut :
une bande d'auto-redressement (162).

6. Dispositif électronique de l'une quelconque des revendications 1 à 5, dans lequel l'écran d'affichage flexible (108) est un écran d'affichage à diodes électroluminescentes pliantes, « Folding Organic Light Emitting Diode » FOLED.

7. Procédé, comprenant :
le pliage d'un dispositif électronique (100) au niveau d'une charnière (106), dans lequel le dispositif électronique (106) inclut :
un écran d'affichage flexible (108), dans lequel l'écran d'affichage flexible (108) a une longueur d'écran d'affichage ; et
un châssis (180a ; 180b), dans lequel le châssis (180a ; 180b) a une longueur de châssis et est couplé à l'écran d'affichage flexible (108) par la charnière (106), dans lequel le châssis (180a ; 180b) inclut :
une première partie de châssis (102) et une seconde partie de châssis (104), dans lequel la première partie de châssis (102) et la seconde partie de châssis (104) fournissent une surface relativement plate et uniforme pour l'écran d'affichage flexible (108) ;
un support d'écran d'affichage flexible (112) couplé à l'écran d'affichage flexible (108), le support d'écran d'affichage flexible (112) étant configuré pour produire une action d'auto-redressement dans une configuration plate ; et
un cadre d'écran d'affichage coulissant (116) couplé à la première partie de châssis (102) et à la seconde partie de châssis (104) au moyen d'un tampon adhésif (114), le cadre d'écran d'affichage coulissant (116) incluant un ou plusieurs mécanismes de coulisseau (118) pour s'adapter à une différence de la longueur de châssis relativement à la longueur d'écran d'affichage quand le dispositif électronique (100) est plié au niveau de la charnière (106), dans lequel chacun de l'un ou des plusieurs mécanismes de coulisseau (118) inclut :
un coulisseau d'écran d'affichage (120) couplé au support d'écran d'affichage flexible (112) ; et
une gorge de coulisseau d'écran d'affichage (122), dans lequel le coulisseau d'écran d'affichage (120) peut se déplacer le long de la gorge de coulisseau d'écran d'affichage (122) pour s'adapter à la différence de la longueur de châssis relativement à la longueur d'écran d'affichage quand le dispositif électronique (100) est plié.

8. Procédé de la revendication 7, dans lequel le châssis en outre inclut :
une bande de contre-force (160).

9. Procédé de l'une quelconque des revendications 7 et 8, dans lequel le châssis en outre inclut :
une bande d'auto-redressement (162).

10. Procédé de l'une quelconque des revendications 7 à 9, dans lequel l'écran d'affichage flexible (118) est un écran d'affichage à diodes électroluminescentes pliantes, « Folding Organic Light Emitting Diode » FOLED.
